# EUROPEAN PATENT APPLICATION

(11) **EP 1 657 734 A2**
(43) Date of publication of application: **17.05.2006**
(21) Application number: 05256926.6
(22) Date of filing: 09.11.2005
(51) Int. Cl.: H01J 17/06, H01J 5/16

(54) **Plasma display apparatus comprising filter**

(30) Priority: 11.11.2004 KR 2004092150
(71) Applicant: LG Electronics, Inc., Youngdungpo-gu Seoul 150-721 (KR)
(72) Inventor: Kim, Kyungku, c/o Hangaram Saekyeong Apt. 502-606, Anyang-si, Gyeonggi-do (KR)
(74) Representative: Camp, Ronald

(57) **Abstract**

A plasma display apparatus invention comprises a plasma display panel (300), and a filter comprising an EMI coating film (350), which has a transparent conduction layer (350a), and a shield conduction layer (350b) formed on the transparent conduction layer and having a number of holes formed therein, wherein the filter is disposed on the plasma display panel. Since a shield conduction layer is formed on a transparent conduction layer, the contrast of a plasma display apparatus can be improved, the bias angle (θ) of an EMI coating film can be easily controlled, and the manufacturing cost of an EMI coating film decreases. The shield layer helps to reduce the level of spurious infra-red radiation emitted by the display.

## Description

The present invention relates to a plasma display apparatus. It more particularly relates to plasma display apparatus comprising a filter.

A conventional plasma display panel comprises a front substrate and a rear substrate made of soda-lime glass. Barrier ribs formed between the front substrate and the rear substrate partition discharge cells. An inert gas injected into the discharge cells, such as helium-xeon (He-Xe) or helium-neon (He-Ne), is excited with a high frequency voltage to generate a discharge. When the discharge is generated, vacuum ultraviolet rays are generated. Vacuum ultraviolet rays excite phosphors formed between the barrier ribs, thus displaying images.

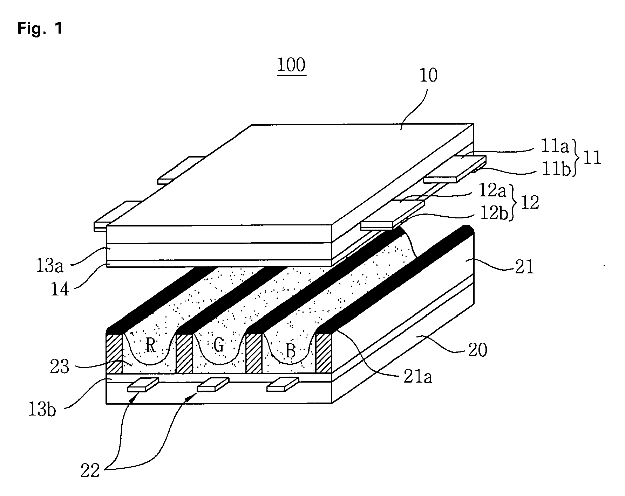

FIG. 1 is a perspective view schematically showing the construction of a conventional plasma display panel of the prior art. As shown in FIG. 1, the plasma display panel in the prior art comprises a front panel and a rear panel. The front panel comprises a front glass substrate 10 and the rear panel comprises a rear glass substrate 20. The front panel and the rear panel are parallel to each other with a predetermined distance therebetween.

A sustain electrode pair 11 and 12 for sustaining the emission of a cell through mutual discharge is formed on the front glass substrate 10. The sustain electrode pair comprises the scan electrode 11 and the sustain electrode 12. The scan electrode 11 comprises a transparent electrode 11a formed of a transparent ITO material and a bus electrode 11b formed of a metal material. The sustain electrode 12 comprises a transparent electrode 12a formed of a transparent ITO material and a bus electrode 12b formed of a metal material.

The scan electrode 11 receives a scan signal for scanning a panel and a sustain signal for sustaining a discharge. The sustain electrode 12 receives a sustain signal. A dielectric layer 13a is formed on the sustain electrode pair 11, 12, and it functions to limit the discharge current and provides insulation between the electrode pairs. A protection layer 14 is formed on a top surface of the dielectric layer 13a and is formed of magnesium oxide (MgO) to facilitate a discharge condition.

Address electrodes 22 intersecting the sustain electrode pair 11, 12 are disposed on the rear glass substrate 20. A dielectric layer 13b is formed on the address electrodes 22 and functions to provide insulation between the address electrodes 22. Barrier ribs 21 are formed on the dielectric layer 13b and partition discharge cells. R, G and B phosphor layer 23 are coated between the barrier ribs 21 and the barrier ribs 21 and radiate a visible ray for displaying images.

A black matrix 21a that has a light shielding function of reducing reflection by absorbing external light generated outside the front glass 10 and a function of improving color purity and contrast of the front glass 10 is arranged on each of the barrier ribs.

The plasma display panel constructed above implements images by applying a high voltage and a high frequency for a plasma discharge. Therefore, a problem arises because significant Electromagnetic Interference (EMI) is generated on the entire surface of the glass substrate.

The plasma display panel in the prior art radiates Near Infrared (NIR) induced by an inert gas such as Ne or Xe. The NIR wavelength is problematic in that it causes the malfunction of electric home appliances since it is similar to a wavelength of the remote controls typically with electric home appliances. To solve several problems of the plasma display panel in the prior art, a glass filter or a film type filter is disposed at the front of the plasma display panel in the prior art.

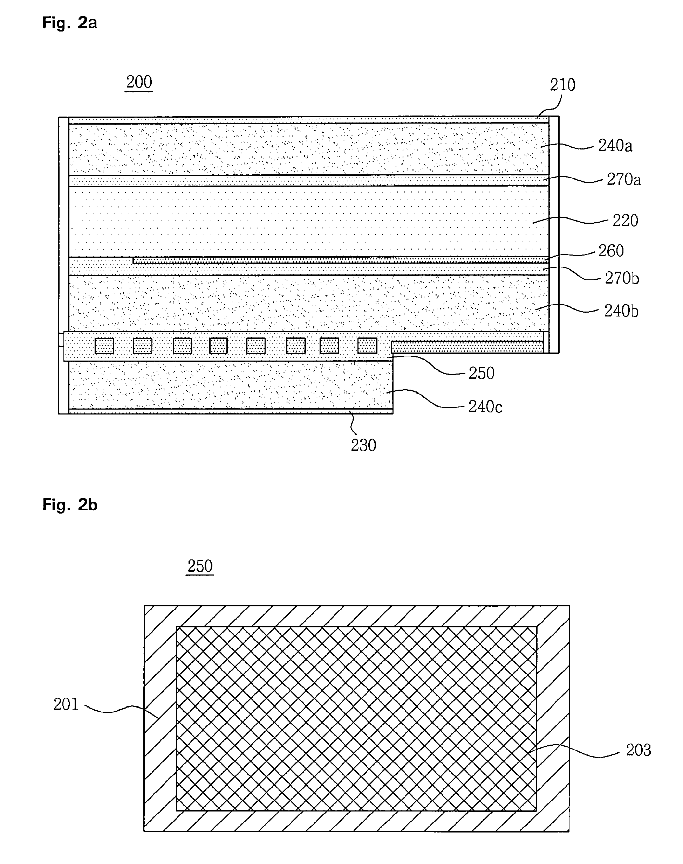

The EMI coating film formed in the glass filter in the prior art is formed as shown in FIGS. 2a and 2b.

FIG. 2a shows the glass filter comprising the EMI coating film in the prior art. FIG. 2b is a plan view of the EMI coating film in the prior art.

As shown in FIG. 2a, the glass filter 200 comprising the EMI coating film in the prior art comprises an Anti-Reflection (AR) coating film 210 for reducing ultraviolet rays and external reflection light, a NIR coating film 230 for NIR shielding, and an EMI coating film 250 for EMI shielding. The glass filter 200 has a glass 220 formed between the AR coating film 210, and the NIR coating film 230 and the EMI coating film 250. The AR coating film 210, the NIR coating film 230 and the EMI coating film 250 are attached to base coating films 240a, 240b and 240c, respectively. The base coating films 240a and 240b are combined with adhesive films 270a and 270b. A black frame 260 is formed in the adhesive film 270b attached to the glass 220.

As shown in FIG. 2b, the EMI coating film 250 in the prior art comprises a conductive mesh 203 for shielding EMI, and a ground part 201 formed on the circumference of the EMI coating film 250 in order to ground the conductive mesh 203.

In the EMI coating film in the prior art, since a mesh pitch is small to shield EMI, the transmittance of light is low. A problem arises because the contrast of the plasma display panel decreases.

In the prior art EMI coating film, the bias angle (θ) must be controlled to prevent the Moire phenomenon due to the mesh 203. In the prior art EMI coating film, since the ground part 201 has to be aligned with the plasma display panel, it is difficult to control the bias angle (θ).

In the prior art EMI coating film, the mesh pitch is small and control of the bias angle is difficult. Therefore, a problem arises because the cost of a mask for forming a mesh increases.

As described above, the prior art EMI coating film has problems in that the cost of a mask rises and the manufacturing cost of the EMI coating film rises.

The film type filter can be attached on the entire surface of the plasma display panel. In the case where the film filter comprises the EMI coating film as shown in FIG. 2b in the same manner as the glass filter, the aforementioned same problems occur.

The present invention seeks to provide an improved plasma display apparatus.

In accordance with a first aspect of the invention, a plasma display apparatus according to the present invention comprises a plasma display panel, and a filter comprising an EMI coating film which comprises a transparent conduction layer and a shield conduction layer formed on the transparent conduction layer and having a number of holes formed therein, wherein the filter is disposed on the plasma display panel.

In accordance with another aspect of the invention, a filter comprises a transparent conduction layer, and an EMI coating film comprising a shield conduction layer which is formed on the transparent conduction layer and has a number of holes formed therein.

In accordance an EMI coating film comprises a transparent conduction layer, and an EMI coating film comprising a shield conduction layer which is formed on the transparent conduction layer and has a number of holes formed therein.

Since a shield conduction layer is formed on a transparent conduction layer, the contrast of a plasma display apparatus is improved.

Since a shield conduction layer is formed on a transparent conduction layer, the bias angle of an EMI coating film is easily controlled.

Since a shield conduction layer is formed on a transparent conduction layer, the cost of a mask decreases and the manufacturing costs of an EMI coating film decreases.

In accordance with another aspect of the invention, a plasma display apparatus comprises a plasma display panel, and a filter comprising an EMI coating film which comprises a transparent conduction layer and a shield conduction layer formed on a transparent conduction layer and having a number of holes formed therein, wherein the filter is disposed on the plasma display panel.

The filter may be a glass filter or a film filter.

The shield conduction layer may be a mesh type shield conduction layer.

A mesh pitch of the shield conduction layer may be 500 µm to 1000 µm.

The transparent conduction layer may comprise any one of ITO, ZnO or ATO.

The shield conduction layer may comprise any one of each oxide material of Cu, Ag, Ni, Ti, Zn, Cr, A1 or Au.

The shield conduction layer may be formed by any one of a sputtering method, a screen printing method, a wet coating method, a thin film sheet junction method or a photolithography method.

In accordance with another aspect of the invention a filter comprises a transparent conduction layer, and an EMI coating film comprising a shield conduction layer which is formed on the transparent conduction layer and has a number of holes formed therein.

The filter may be either a glass filter or a film filter.

The shield conduction layer may be a mesh type shield conduction layer.

The mesh pitch of the shield conduction layer may be 500 µm to 1000 µm.

The transparent conduction layer may comprise any one of ITO, ZnO or ATO.

The shield conduction layer may comprise any one of each oxide material of Cu, Ag, Ni, Ti, Zn, Cr, A1 or Au.

The shield conduction layer may be formed by any one of a sputtering method, a screen printing method, a wet coating method, a thin film sheet junction method or a photolithography method.

In accordance with another aspect of the invention an EMI coating film comprises a transparent conduction layer, and an EMI coating film comprising a shield conduction layer which is formed on the transparent conduction layer and has a number of holes formed therein.

The shield conduction layer may be a mesh type shield conduction layer.

The mesh pitch of the shield conduction layer may be 500 µm to 1000 µm.

The transparent conduction layer may comprise any one of ITO, ZnO or ATO.

The shield conduction layer may comprise any one of each oxide material of Cu, Ag, Ni, Ti, Zn, Cr, Al or Au.

The shield conduction layer may be formed by any one of a sputtering method, a screen printing method, a wet coating method, a thin film sheet junction method or a photolithography method.

Embodiments of the invention will now be described, by way of non-limiting example only, with reference to the drawings in which:

FIG. 1 is a perspective view schematically showing the construction of a plasma display panel in the prior art;

FIG. 2a shows a glass filter comprising an EMI coating film in the prior art;

FIG. 2b is a plan view of the EMI coating film in the prior art;

FIG. 3a shows a glass filter comprising an EMI coating film according to an embodiment of the present invention;

FIG. 3b is a plan view of the EMI coating film according to an embodiment of the present invention; and

FIG. 4 shows a film filter comprising an EMI coating film according to an embodiment of the present invention.

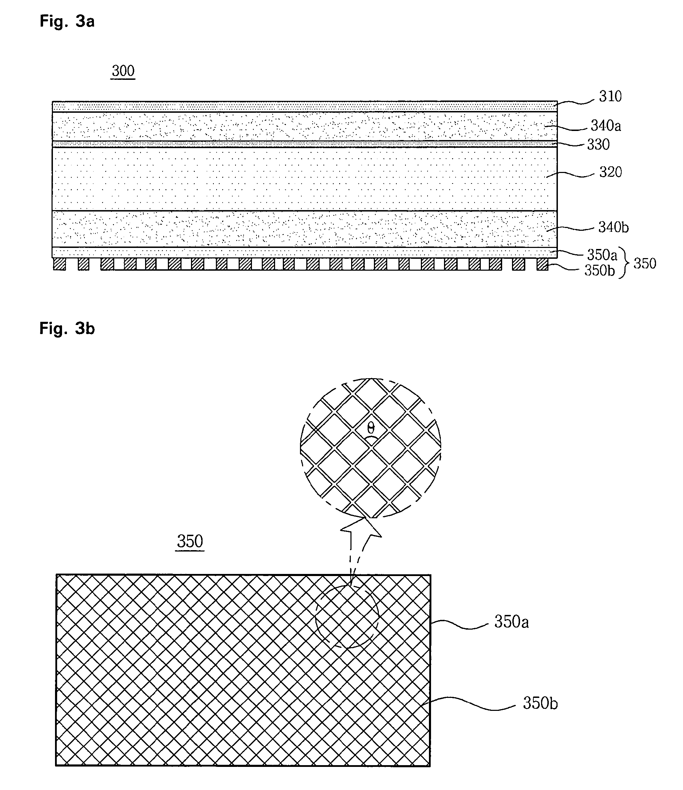

As shown in FIG. 3a, a glass filter 300 comprises a glass 320, an AR coating film 310 for shielding ultraviolet radiation and reducing external reflection light, an NIR coating film 310 for shielding NIR, an EMI coating film 350 for shielding EMI, and a color dye layer 330 for shielding neon (Ne).

The color dye layer 330 shields light of a specific color, which is generated due to Ne when the plasma display panel is driven. One side of the color dye layer 330 is brought in contact with one side of the glass 320. The color dye layer 330 and the glass 320 are combined through a surface contact.

A first base coating film 340a is comprised of a material such as Poly Ethylene Terephthalate (PET) or Triacetyl Acetyl Cellulose (TAC). One side of the first base coating film 340a is brought in contact with the other side of the color dye layer 330.

The AR coating film and the NIR coating film are integrated into one film 310 in order to shield the ultraviolet rays, reduce external reflection light and shield NIR. One side of the AR coating film and the NIR coating film is brought in contact with the other side of the base coating film 340a.

A second base coating film 340b is comprised of a material such as PET or TAC and is brought in contact with the other side of the glass 320.

The EMI coating film 350 according to the present embodiment is formed to shield EMI and is brought in contact with the other side of the second base coating film 340b. As shown in FIG. 3b, the EMI coating film 350 comprises a transparent conduction layer 350a formed of a material, such as Indium Tin Oxide (ITO) ZnO or ATO, and a shield conduction layer 350b, which is formed on the transparent conduction layer 350a and has a number of holes formed therein. The shield conduction layer 350b of the EMI coating film according to the present embodiment is a mesh type shield conduction layer.

In the EMI coating film 350 according to the present embodiment, the transparent conduction layer 350a is connected to the ground so that the shield conduction layer 350b is grounded, instead of the ground part 201 comprised in the EMI coating film 250 in the prior art, which is shown in FIG. 2b. Since the transparent conduction layer 350a is connected to the ground and the shield conduction layer 350b is grounded according as described above, the mesh pitch of the shield conduction layers 350b is more than the mesh pitch of the prior art.

That is, the smaller the mesh pitch, the greater the EMI shield ability. In the EMI coating film in the prior art, since only the conductive mesh 203 of FIG. 2b functions to shield EMI, the mesh pitch is small. In the EMI coating film according to the present embodiment, however, not only the shield conduction layer 350b, but also the transparent conduction layer 350a function to shield EMI. Therefore, the mesh pitch can become large. Although the mesh pitch of the prior art is 300 µm, the mesh pitch in embodiments of the present invention can be set to 500 µm to 1000 µm.

Therefore, in the EMI coating film according to the present embodiment, since the transmittance of light increases, the contrast of the plasma display panel improves. In the EMI coating film according to the present embodiment, the bias angle(θ) is controlled by rotating the EMI coating film according to an embodiment of the present invention without considering the ground part in the prior art. In the EMI coating film according to an embodiment of the present invention, since the mesh pitch is large and the bias angle(θ) is easily controlled, the shield conduction layer 350b is formed using an inexpensive cheap mask.

In the present embodiment the shield conduction layer 350b is formed using conductive oxide such as Cu, Ag, Ni, Ti, Zn, Cr, A1 or Au by any one of a sputtering method, a screen printing method, a wet coating method, a thin film sheet junction method or a photolithography method. In the thin film sheet junction method, the shield conduction layer 350b is formed on the transparent conduction layer 350a using a thin film sheet in which the shield conduction layer 350b is previously formed.

The glass filter comprising the EMI coating film is disposed on the plasma display panel, thus forming the plasma display apparatus.

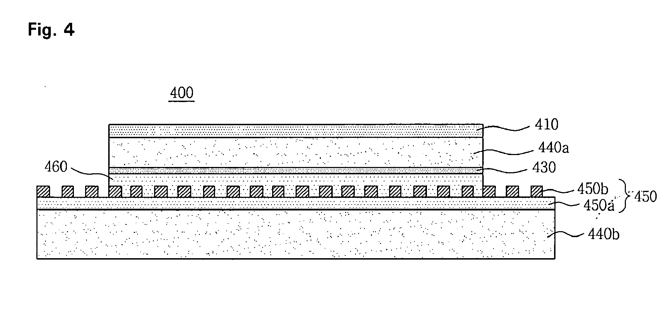

As shown in FIG. 4, a film filter 400 comprises an AR coating film for shielding ultraviolet radiation and reducing external reflection light, a NIR coating film for shielding NIR, an EMI coating film 450 for shielding EMI, and a color dye layer 430 for shielding Ne. The function of each of the films is the same as that of the first embodiment. Description thereof will therefore be omitted.

The AR coating film and the NIR coating film are integrated into one film 410. A third base coating film 440a is formed between the AR coating film and the NIR coating film, and the color dye layer 430. The EMI coating film 450 according to the present embodiment is formed between a transparent processing resin 460 and a fourth base coating film 440b.

The EMI coating film 450 comprised in the film filter 400 according to the present embodiment comprises a transparent conduction layer 450a formed of a material, such as ITO, ZnO or ATO, and a shield conduction layer 450b, which is formed on the transparent conduction layer 450a and has a number of holes formed therein. The shield conduction layer 450b of the EMI coating film is a mesh type shield conduction layer.

In an embodiment of the present invention the EMI coating film 450, the transparent conduction layer 450a is connected to the ground so that the shield conduction layer 450b is grounded, instead of the ground part 201 comprised in the EMI coating film 250 in the prior art, which is shown in FIG. 2b. Since the transparent conduction layer 450a is connected to the ground and the shield conduction layer 450b is grounded according as described above, the mesh pitch of the shield conduction layers 450b is greater than the mesh pitch of the prior art.

In the EMI coating film in the prior art, since only the conductive mesh 203 of FIG. 2b functions to shield EMI, the mesh pitch is small. In the EMI coating film according to an embodiment of the present invention, however, not only the shield conduction layer 450b, but also the transparent conduction layer 450a function to shield EMI. Therefore, the mesh pitch can become large. Although the mesh pitch of the prior art is 300 µm, the mesh pitch in the present embodiment can be set to 500 µm to 1000 µm.

Therefore, the EMI coating film according to the present embodiment can improve the contrast of the plasma display panel. In the EMI coating film according to an embodiment of the present invention, the bias angle (θ) is controlled by only rotating the EMI coating film according to an embodiment of the present invention. In addition, in the EMI coating film according to an embodiment of the present invention, the shield conduction layer 450b is formed using an inexpensive mask.

The shield conduction layer 450b is formed using conductive oxide such as Cu, Ag, Ni, Ti, Zn, Cr, A1 or Au by any one of a sputtering method, a screen printing method, a wet coating method, a thin film sheet junction method or a photolithography method. In the thin film sheet junction method, the shield conduction layer 450b is formed on the transparent conduction layer 450a using a thin film sheet in which the shield conduction layer 450b is previously formed.

The film filter comprising the EMI coating film according to an embodiment of the present invention is disposed on the plasma display panel, thus forming the plasma display apparatus.

While the present invention has been described with reference to the particular illustrative embodiments, it is not to be restricted by the embodiments but only by the appended claims. It is to be appreciated that those skilled in the art can change or modify the embodiments without departing from the scope of the invention.

## Claims

1. A plasma display apparatus, comprising:
a plasma display panel; and
a filter comprising an EMI coating film which comprises a transparent conduction layer and a shield conduction layer formed on the transparent conduction layer and having a number of holes formed therein, wherein the filter is disposed on the plasma display panel.

2. The plasma display apparatus as set forth in claim 1, wherein the filter is either a glass filter or a film filter.

3. The plasma display apparatus as set forth in claim 1, wherein the shield conduction layer is a mesh type shield conduction layer.

4. The plasma display apparatus as set forth in claim 3, wherein a mesh pitch of the shield conduction layer is 500 µm to 1000 µm.

5. The plasma display apparatus as set forth in claim 1, wherein the transparent conduction layer comprises any one of ITO, ZnO or ATO.

6. The plasma display apparatus as set forth in claim 1, wherein the shield conduction layer comprises any one of each oxide material of Cu, Ag, Ni, Ti, Zn, Cr, Al or Au.

7. The plasma display apparatus as set forth in claim 1, wherein the shield conduction layer is formed by any one of a sputtering method, a screen printing method, a wet coating method, a thin film sheet junction method or a photolithography method.

8. A filter disposed on a plasma display panel, comprising:
a transparent conduction layer; and
an EMI coating film comprising a shield conduction layer which is formed on the transparent conduction layer and has a number of holes formed therein.

9. The filter as set forth in claim 8, wherein the filter is either a glass filter or a film filter.

10. The filter as set forth in claim 8, wherein the shield conduction layer is a mesh type shield conduction layer.

11. The filter as set forth in claim 10, wherein a mesh pitch of the shield conduction layer is 500 µm to 1000 µm.

12. The filter as set forth in claim 8, wherein the transparent conduction layer comprises any one of ITO, ZnO or ATO.

13. The filter as set forth in claim 8, wherein the shield conduction layer comprises any one of each oxide material of Cu, Ag, Ni, Ti, Zn, Cr, Al or Au.

14. The filter as set forth in claim 8, wherein the shield conduction layer is formed by any one of a sputtering method, a screen printing method, a wet coating method, a thin film sheet junction method or a photolithography method.

15. An EMI coating film, comprising:
a transparent conduction layer which allows light to pass through; and
a shield conduction layer formed on the transparent conduction layer and having a number of holes formed therein.

16. The EMI coating film as set forth in claim 15, wherein the shield conduction layer is a mesh type shield conduction layer.

17. The EMI coating film as set forth in claim 16, wherein a mesh pitch of the shield conduction layer is 500 µm to 1000 µm.

18. The EMI coating film as set forth in claim 15, wherein the transparent conduction layer comprises any one of ITO, ZnO or ATO.

19. The EMI coating film as set forth in claim 15, wherein the shield conduction layer comprises any one of each oxide material of Cu, Ag, Ni, Ti, Zn, Cr, Al or Au.

20. The EMI coating film as set forth in claim 15, wherein the shield conduction layer is formed by any one of a sputtering method, a screen printing method, a wet coating method, a thin film sheet junction method or a photolithography method.
